# EUROPÄISCHE PATENTSCHRIFT

(11) **EP 1 498 654 B1**
(45) Veröffentlichungstag und Bekanntmachung des Hinweises auf die Patenterteilung: **17.09.2008**
(21) Anmeldenummer: 04012003.2
(22) Anmeldetag: 21.05.2004
(51) Int. Cl.: F16L 39/04

(54) **Vorrichtung zur Behandlung von Werkstücken**
Device for the treatment of workpieces
Dispositif servant à traiter des pièces

(30) Priorität: 15.07.2003 DE 10331946
(43) Veröffentlichungstag der Anmeldung: 19.01.2005
(73) Patentinhaber: Schott AG, 55122 Mainz (DE)
(72) Erfinder: Arnold, Gregor, 55294 Bodenheim (DE); Lüttringhaus-Henkel, Andreas, 64289 Darmstadt (DE); Klein, Jürgen, Dr., 55127 Mainz (DE); Behle, Stephan, Dr., 55239 Gau-Odernheim (DE)
(74) Vertreter: Herden, Andreas F.

(56) Entgegenhaltungen:
- EP-A- 0 959 287
- EP-A- 1 070 900
- GB-A- 512 744
- US-A- 3 999 766
- US-B1- 6 286 546

## Beschreibung

### Art der Erfindung

Die Erfindung betrifft eine Vorrichtung zur Behandlung von Werkstücken mit Fluiden im Allgemeinen und zur Beschichtung von Hohlkörpern im Speziellen.

### Hintergrund der Erfindung

Kunststoffe, insbesondere transparente Kunststoffe gewinnen zunehmend an Bedeutung und verdrängen in vielen Bereichen Glas als bevorzugtem Werkstoff.

Ein Beispiel hierfür sind Getränkeflaschen, welche vor einigen Jahren noch fast ausschließlich aus Glas bestanden und heutzutage bereits zu einem Großteil aus PET-Kunststoff hergestellt werden. Der Grund hierfür liegt in der enormen Gewichtsersparnis.

Kunststoffflaschen können aber auch einige Nachteile gegenüber Glasflaschen aufweisen, z.B. sind die verwendeten Kunststoffe wie PET nicht ausreichend gasundurchlässig, so dass insbesondere bei kohlensäurehaltigen Getränken die Haltbarkeitsdauer geringer ist als bei Glasflaschen, sofern nicht besondere Anstrengungen unternommen werden.

Aus diesem Grund werden die Kunststoffflaschen mittels PICVD-Verfahren von innen und/oder außen mit einer Barriereschicht versehen, was zu einer Erhöhung der Haltbarkeitsdauer führt.

Da es sich bei Getränkeflaschen um Massenware handelt, besteht ein enormer Kostendruck, so dass für die Beschichtungsverfahren und diesbezüglichen Vorrichtungen eine immerwährende Nachfrage nach Verbesserungen besteht.

Für eine effiziente Beschichtung von PET-Flaschen und anderen Werkstücken aus dielektrischem Material, vorzugsweise Kunststoffe, ist es folglich wünschenswert, eine Vorrichtung zu entwickeln, welche sehr kurze Taktzeiten und damit einen hohen Durchsatz ermöglicht. Typische geforderte Probendurchsätze liegen im Bereich von 10.000 Flaschen pro Stunde.

Aus der Druckschrift WO 00/58631 ist eine derartige Maschine mit einem Förderkarussell für die Behandlung von Hohlkörpern bekannt, bei welcher 20 identische Behandlungsstationen auf dem Förderkarussell angeordnet sind.

Die in der vorstehend benannten Druckschrift definierte Erfindung geht davon aus, dass das Gewicht und Volumen der Pumpen verhindert, dass diese auf dem Karussell mitgenommen werden. Daher sind die Pumpen ortsfest und es wird ein rotierender Anschluss oder Verteiler eingesetzt, um die Pumpen mit den Stationen zu verbinden.

Weiter sind die 20 Stationen in zwei Gruppen unterteilt, wobei jede Gruppe einer unabhängigen und gleichwertigen Druckquelle zugeordnet ist bzw. die Gruppen danach differenziert sind, an welche Pumpen sie angeschlossen werden. Mittels des rotierenden Verteilers ist festgelegt, an welchen Zeitpunkten der Rotationsbewegung des Förderkarussells eine bestimmte Pumpe mit einer bestimmten Behandlungsstation in Verbindung steht, wobei der Verteiler zu diesem Zweck einen rotierenden Kranz mit 20 Öffnungen und einen feststehenden Kranz mit jeweils 3 Schlitzen für die beiden Gruppen beinhaltet.

Diese Maschine weist jedoch eine Reihe von schwerwiegenden Nachteilen auf.

Die stationäre Anordnung der Pumpen ist nachteilig, da die Wege von den Stationen bis zur Pumpe relativ lang sind und daher die Pumpleistung reduziert ist.

Ferner können Stäube oder abgeplatzte Beschichtungsfragmente die Evakuierungsleitungen und den Verteiler verschmutzen was die Dichtigkeit beeinträchtigt und einen erhöhten Wartungsaufwand nach sich zieht.

Besonders nachteilig jedoch ist der Einsatz eines drehbaren Verteilers mit axial angeordneten Scheiben. Derartige Verteiler sind höchst schwierig abzudichten und besonders anfällig gegen Störungen durch Fremdkörper. Darüber hinaus gestattet der Verteiler aufgrund der fest vorgegebenen öffnungsanordnung keinerlei Variation des Prozessablaufs, so dass dies ein unflexibles Konzept darstellt.

Beispielsweise beschreibt das Dokument EP-A-1 070 900 eine Verbindungsvorrichtung zur Verbindung zumindest einer stationären Fluidleitung mit zumindest einer relativ dazu bewegbaren Fluidleitung, die eine Umlaufbewegung um eine Drehachse ausführen kann. Die Verbindungsvorrichtung wird insbesondere zur Lampenherstellung verwendet. Es ist zwischen einem stationären Teil und einem zur Drehachse koaxialen Drehteil zumindest ein Ringkanal vorgesehen, in dem eine im stationären Teil vorgesehene stationäre Anschlußleitung und eine im Drehteil vorgesehene umlaufende Anschlußleitung münden.

### Allgemeine Beschreibung der Erfindung

Die Erfindung hat sich daher die Aufgabe gestellt, eine Vorrichtung zur Behandlung von Werkstücken bereit zu stellen, welche die Nachteile bekannter Vorrichtungen vermeidet oder zumindest mindert.

Eine weitere Aufgabe der Erfindung ist es, eine Vorrichtung zur Behandlung von Werkstücken bereit zu stellen, welche zuverlässig und wartungsarm arbeitet.

Noch eine Aufgabe der Erfindung ist es, eine Vorrichtung zur Behandlung von Werkstücken bereit zu stellen, welche flexibel an die Bedürfnisse des Nutzers oder des gewünschten Prozessablaufs anpassbar ist.

Noch eine weitere Aufgabe der Erfindung ist es, eine Vorrichtung zur Behandlung von Werkstücken bereit zu stellen, welche ein effizientes Evakuieren gestattet.

Die Aufgabe der Erfindung wird in überraschend einfacher Weise bereits durch den Gegenstand der unabhängigen Ansprüche gelöst. Vorteilhafte Weiterbildungen der Erfindung sind in den Unteransprüchen definiert.

Gemäß einer Ausführungsform der Erfindung wird eine Vorrichtung zur Behandlung von Werkstücken, insbesondere zur Plasmabeschichtung von Hohlkörpern unter Fluidbeaufschlagung bereit gestellt, welche zumindest eine Behandlungseinrichtung, vorzugsweise eine Mehrzahl von Behandlungseinrichtungen zur Aufnahme jeweils zumindest eines Werkstücks umfasst. Insbesondere werden die Werkstücke innen und/oder außen mittels einem PICVD-Verfahren (Plasma Impulse Chemical Vapor Deposition) beschichtet. Die Behandlungseinrichtungen sind auf einem Rotor oder Förderkarussell befestigt und rotieren im Betrieb um die Rotorachse, wobei bevorzugt ein Behandlungszyklus mit einer Rotordrehung von 360° korreliert ist.

Die Vorrichtung umfasst ferner eine Fluiddrehdurchführung zum Zuführen zumindest eines Fluids auf den Rotor und/oder zum Abführen zumindest eines Fluids von dem Rotor. Bevorzugt werden die Behandlungseinrichtungen sukzessive in mehreren Stufen mittels Vakuumpumpen evakuiert, wobei insbesondere zumindest ein Teil der Vakuumpumpen ortsfest, d.h. außerhalb des Rotors angeordnet ist. Daher werden z.B. Vakuumkanäle oder -leitungen auf den Rotor geführt, was über die Fluiddrehdurchführung bewerkstelligt wird.

Auf der anderen Seite werden die Behandlungseinrichtungen mit Fluiden oder Prozessgasen versorgt, um z.B. eine Plasmabeschichtung der Werkstücke, insbesondere Kunststoffgetränkeflaschen vorzunehmen. Auch diese Fluide werden vorzugsweise z.B. von einer ortsfesten Fluidversorgungseinrichtung über die Fluiddrehdurchführung auf den Rotor geführt. Insbesondere weisen der Zapfen und die Hülse einen oder mehrere Fluidkanäle auf, durch welchen bzw. welche das oder die Fluide der Behandlungseinrichtung auf dem Rotor zugeführt, bzw. aus der Behandlungseinrichtung auf dem Rotor abgeführt werden. Demgemäß definiert die Fluiddrehdurchführung vorzugsweise einen oder mehrere Fluidkanäle über welche das oder die Fluide von Anschlüssen an der Hülse zu mit diesen verbundenen Anschlüssen an dem Zapfen und/oder umgekehrt geleitet werden.

Die erfindungsgemäße Fluiddrehdurchführung weist einen vorzugsweise im wesentlichen zylindrischen Zapfen oder Achszapfen und eine vorzugsweise im wesentlichen hohlzylindrische Hülse oder Ringhülse auf. Der Zapfen ist rotierbar in der Hülse angeordnet und zumindest abschnittsweise an seiner Mantelfläche gegen die Hülse gedichtet.

Der Zapfen ist ferner vorzugsweise konzentrisch in der Hülse angeordnet und die Fluiddrehdurchführung erstreckt sich entlang der Rotorachse.

Die erfindungsgemäße radiale oder konzentrische Konstruktion der Fluiddrehdurchführung weist eine Reihe von Vorteilen auf.
Die Fluiddrehdurchführung ist konstruktiv einfach und zuverlässig. Weiter können kostengünstige Standarddichtungen verwendet werden. Weiter ist eine kontinuierliche Fluidverbindung über den gesamten Drehwinkel von 360° zwischen dem ortsfesten und dem rotierenden Teil möglich.

Darüber hinaus eignet sich die erfindungsgemäße Fluiddrehdurchführung für die Durchleitung einer Mehrzahl von Fluiden, da der Durchmesser in gewissen Grenzen unabhängig von der Anzahl der implementierten Fluidkanäle ist. Weiter zeichnet sich die Fluiddrehdurchführung durch eine kompakte Bauweise aus und kann daher leicht zugänglich angeordnet werden. Dadurch entsteht ein verringerter Aufwand beim Wechseln der Dichtungen. Auch das Auffinden und Beseitigen von Lecks gestaltet sich durch die verbesserte Zugänglichkeit einfacher.

Es wird also eine Rundläufer-Vorrichtung mit einem kontinuierlich drehenden Rotor mit radial angeordneten identischen Beschichtungsstationen mit hoher Leistung für den industriellen Beschichtungsprozess bereit gestellt.

Die Fluiddrehdurchführung ist besonders bevorzugt derart an der Vorrichtung angebracht, dass die Hülse drehfest an dem Rotor befestigt ist und mit diesem mitrotiert und der Zapfen ortsfest ist. Hierbei ist die Anordnung der Anschlüsse besonders einfach an die Beschichtungsvorrichtung anpassbar. Aber auch eine umgekehrte Auslegung mit einem im Betrieb rotierenden Zapfen und einer ortsfesten Hülse ist möglich.

Vorzugsweise weist der Zapfen für jedes Fluid einen im wesentlichen L- oder U-förmigen Kanal mit zumindest einem axialen und einem radialen Kanalabschnitt auf, wobei der radiale Kanalabschnitt in der Mantelfläche des Zapfens mündet, um die Verbindung mit Kanalabschnitten in der Hülse zu erreichen.

Weiter weisen die Hülse und/oder der Zapfen vorzugsweise zumindest einen Ringkanal, welcher um den Zapfen umläuft auf, wobei der Ringkanal zumindest zeitweise, vorzugsweise kontinuierlich mit dem radialen Kanalabschnitt des Zapfens verbunden ist, wobei der axiale Kanalabschnitt, der radiale Kanalabschnitt und der Ringkanal einen Fluidkanal in der Fluiddrehdurchführung bilden oder teil eines solchen sind.

Beidseits des Ringkanals sind der Zapfen und die Hülse vorzugsweise mittels je einer radial angeordneten Dichtung, insbesondere Ringdichtung gedichtet. D.h. die Dichtungen dichten gegen ein axiales Ein- oder Ausströmen von Fluid zwischen dem Zapfen und der Hülse. Die Ringdichtungen sind z.B. als Metall- oder Gummidichtungen realisiert und werden vorzugsweise mit einem Dichtmittel, z.B. einem vakuumtauglichen Öl geschmiert.

Auch hierin ist ein Vorteil der erfindungsgemäßen Fluiddrehdurchführung begründet, da in einfacher Weise Dichtmittelleitungen vorgesehen sein können, über welche sogar im Betrieb der Vorrichtung eine ggf. kontinuierliche oder dauerhafte Dichtmittelzuführung oder Schmierung der Dichtungen bewerkstelligt werden kann. Dadurch hat die Fluiddrehdurchführung eine längere Standzeit und weniger Wartungsaufwand.

Gemäß einer besonderen Weiterbildung der Erfindung weist die Hülse eine Mehrzahl von radial angeordneten und in einer axialen Ebene sternartig verteilten Leitungsanschlüssen auf, wobei jeder Behandlungseinrichtung ein eigener Leitungsanschluss zugeordnet ist. Alternativ kann rotorseitig aber auch lediglich ein Leitungsanschluss an der Fluiddrehdurchführung vorgesehen sein und sich die Fluidleitungen zwischen der Fluiddrehdurchführung und den Behandlungseinrichtungen verzweigen, um eine Verteilung des Fluids bzw. Vakuums auf die Behandlungseinrichtungen zu erreichen.

Vorzugsweise weist die Fluiddrehdurchführung eine Mehrzahl von Fluidkanälen auf. Dies wird z.B. dadurch realisiert, dass der Zapfen eine Mehrzahl von Känalen mit jeweils einem axialen und einem radialen Kanalabschnitt aufweist, wobei die radialen Kanalabschnitte sternförmig auseinanderlaufen und in der Mantelfläche des Zapfens münden und die Hülse jeweils entsprechende Kanalabschnitte und Leitungsanschlüsse besitzt.
Die axialen Kanalabschnitte sind vorzugsweise ringartig um die Drehachse versetzt angeordnet.

Besonders bevorzugt durchläuft die Behandlungseinrichtung im Betrieb zumindest eine Evakuierungsphase, in welcher die Behandlungseinrichtungen von Normaldruck um einige Größenordnungen evakuiert werden und zumindest eine Beschichtungsphase, in welcher die Plasmainnenbeschichtung der hohlen Werkstücke unter Beaufschlagung mit einem Prozessfluid oder -gas vorgenommen wird. Insbesondere wird die Beschichtung im Durchflussbetrieb durchgeführt, so dass die Behandlungseinrichtung in der Evakuierungsphase über einen ersten Fluidkanal in der Fluiddrehdurchführung mit einer ersten Vakuumpumpe oder Fördereinrichtung und in der Beschichtungsphase über einen zweiten separaten Fluidkanal in der Fluiddrehdurchführung oder Drehkupplung mit einer zweiten Vakuumpumpe verbunden ist.

Hierzu weisen die Hülse und/oder der Zapfen eine Mehrzahl von Ringkanälen auf, welche mit jeweils einem der radialen Kanalabschnitte verbunden sind, wobei jeweils ein radialer Kanalabschnitt und ein zugeordneter Ringkanal auf einer Ebene liegen und ein Übergangskanalpaar bilden und die verschiedenen Übergangskanalpaare axial zueinander versetzt sind. Vorzugsweise ist zwischen den Ringkanälen jeweils zumindest eine Ringdichtung vorgesehen, um die Kanäle gegeneinander zu dichten.

Die Ringkanäle sind vorzugsweise vollständig umlaufend ausgebildet und die Leitungsanschlüsse des Zapfens und der Hülse sind während der Drehung des Rotors über 360° kontinuierlich miteinander verbunden, was z.B. mit einer Scheibenanordnung ohne weiteres nicht möglich ist.

Auf den ersten Blick mag die kontinuierliche Verbindung nachteilig erscheinen, da die Behandlungseinrichtungen unterschiedlichen Prozessphasen unterworfen sind, welche unterschiedliche Prozessparameter erfordern. Jedoch wird gemäß einer bevorzugten Weiterbildung der Erfindung das Zuführen und/oder das Abführen des Fluids mittels einer oder mehreren Ventilanordnungen, welche vorzugsweise an dem Rotor angeordnet sind, gesteuert. Somit wird die Prozesssteuerung mittels der Ventile unabhängig von der Fluiddrehdurchführung zeitlich gesteuert.

Daraus resultiert ein Doppelnutzeneffekt: Einerseits wird die mechanisch anspruchsvolle Drehdurchführung sehr vereinfacht und weniger störanfällig und andererseits wird die Prozesssteuerung flexibilisiert.

Bezüglich der Ventilanordnung und -steuerung wird auf die Anmeldung "vorrichtung und Verfahren zur Behandlung von Werkstücken" PCT/EP03/05473, angemeldet am 26.05.2003 und auf die Anmeldung "Mehrplatz-Beschichtungsvorrichtung und Verfahren zur Plasmabeschichtung" DE-102 53 513.2, angemeldet am 16.11.2002 derselben Anmelderin verwiesen, welche hiermit vollumfänglich durch Referenz zum Gegenstand dieser Offenbarung gemacht werden.

Besonders bevorzugt weist die Fluiddrehdurchführung zumindest einen oder mehrere Gaszuführungskanäle und einen oder mehrere Evakuierungskanäle auf, wobei über die Gaszuführungskanäle der Behandlungseinrichtung auf dem Rotor ein Fluid zugeführt wird und die Behandlungseinrichtungen mittels einer oder mehrerer Vakuumpumpen über den Evakuierungskanal während der Evakuierungsphase(n) und/oder der Beschichtungsphase(n) evakuiert werden, wobei vorzugsweise für jede Phase ein separater Druckregler vorgesehen ist.

In vorteilhafter Weise ist also über dieselbe Fluiddrehdurchführung sowohl die Prozessgasversorgung als auch die Evakuierung realisiert.

Die Gaszuführungskanäle und Evakuierungskanäle unterscheiden sich ferner funktionsbedingt in Bezug auf deren Durchmesser. So weisen die Evakuierungskanäle bevorzugt einen Innendurchmesser von mindestens 25 mm, bevorzugt zwischen 50 mm und 250 mm und besonders bevorzugt zwischen 100 mm und 160 mm auf. Die Gaszuführungskanäle weisen bevorzugt einen Innendurchmesser von 5 mm bis 50 mm, besonders bevorzugt zwischen 10 mm und 30 mm, insbesondere etwa 25 mm auf.

Vorzugsweise werden die Behandlungseinrichtungen während der Behandlung der Werkstücke zumindest zeitweise mittels Vakuumpumpen evakuiert, wobei die Evakuierung mehrstufig durchgeführt wird und zumindest eine der Vakuumpumpen auf dem Rotor angeordnet ist. Dabei ist insbesondere in zumindest einem Evakuierungskanal eine Vakuumpumpe stromaufwärts und eine Vakuumpumpe stromabwärts der Fluiddrehdurchführung vorgesehen.

In vorteilhafter Weise kann die Fluiddrehdurchführung dadurch für einen Vakuumbereich > 1 mbar ausgelegt sein und mit kleineren Leitungsquerschnitten ausgeführt werden.
Es bestehen also in vorteilhafter Weise relativ geringe Anforderungen in Bezug auf die Leckageraten in dem Druckbereich > 1 mbar. Die Fluiddrehdurchführung kommt daher mit einer Leckrate von < 10⁻² mbar*l/sec aus.

Somit ist sie preiswert herstellbar.

Ferner lässt sich durch die kleineren Querschnitte die Fluiddrehdurchführung auch mit mehreren Fluidkanälen, d.h. 2, 3, 4, 5, 6 oder mehr wirtschaftlich und in kompakter Bauweise herstellen.

Im Folgenden wird die Erfindung anhand von Ausführungsbeispielen und unter Bezugnahme auf die Zeichnungen näher erläutert, wobei gleiche und ähnliche Elemente mit gleichen Bezugszeichen versehen sind und die Merkmale der verschiedenen Ausführungsbeispiele miteinander kombiniert werden können.

### Kurzbeschreibung der Figuren

Es zeigen:
- Fig. 1: eine schematische Seitenansicht einer Behandlungsvorrichtung,
- Fig. 2: einen Längsschnitt durch eine Fluiddrehdurchführung gemäß einer ersten Ausführungsform der Erfindung,
- Fig. 3: einen Längsschnitt durch eine Fluiddrehdurchführung gemäß einer zweiten Ausführungsform der Erfindung,
- Fig. 4: einen Querschnitt entlang der Schnittlinie A-A in Fig. 3,
- Fig. 5: einen Querschnitt entlang der Schnittlinie B-B in Fig. 3, und
- Fig. 6: eine blockdiagrammartige Darstellung einer Vakuumpumpenanordnung.

### Detaillierte Beschreibung der Erfindung

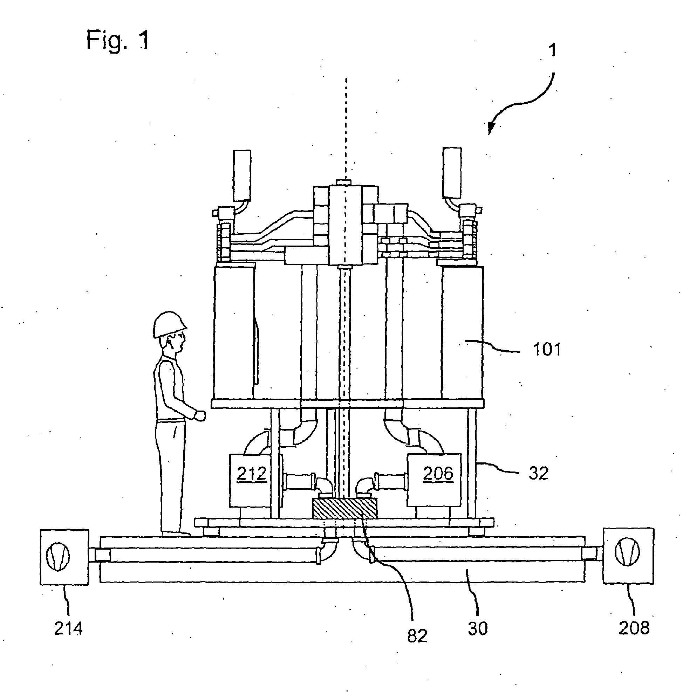

Fig. 1 zeigt eine Vorrichtung 1 zur Plasmabeschichtung von Kunststoffhohlkörpern, welche in einer Mehrzahl von Behandlungseinrichtungen 101 mittels des PICVD-Verfahrens beschichtet werden.

Die Vorrichtung 1 umfasst ein Plasmarad oder einen Rotor 32, auf welchem die Behandlungseinrichtungen 101 oder Plasmastationen befestigt sind. Der Rotor 32 rotiert im Betrieb gegenüber einem ortsfesten Standboden 30. Im Zentrum der Vorrichtung 1 befindet sich eine Fluiddrehdurchführung oder Gasdrehdurchführung 82, über welche ein Betriebsmittel oder Prozessgas den umlaufenden Behandlungseinrichtungen 101 zugeführt wird und die Behandlungseinrichtungen 101 mittels auf dem Rotor und ortsfest angeordneter Pumpen evakuiert zu werden.

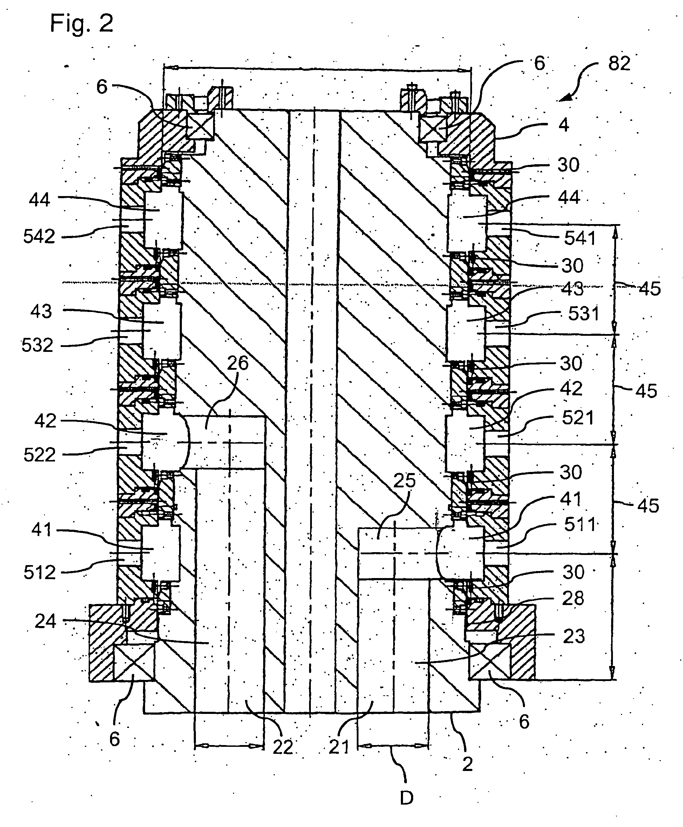

Fig. 2 zeigt eine erste Ausführungsform der Fluiddrehdurchführung oder Drehdurchführung 82.

Die Drehdurchführung 82 umfasst einen drehfest mit dem Standboden 30 verbundenen Zapfen oder Achszapfen 2 und eine drehfest mit dem Rotor 32 verbundene Hülse oder Ringhülse 4. Die Ringhülse 4 ist mittels Drehlagern 6 drehbar an dem Zapfen 2 gelagert.

Die Hülse 4 weist vier Ringkanäle 41, 42, 43, 44 auf, welche axial versetzt zueinander angeordnet sind. Mit jedem Ringkanal ist eine Mehrzahl von Anschlussbohrungen verbunden, wobei jeweils eine Anschlussbohrung einer Behandlungseinrichtung 101 zugeordnet ist. In Fig. 2 sind je Ringkanal jeweils zwei gegenüberliegende Anschlussbohrungen 511, 512, 521, 522, 531, 532, 541, 542 zu sehen.

Der Zapfen 2 weist zwei Fluid- oder Evakuierungskanäle 21, 22 mit einem Innendurchmesser D von 102 mm auf. Die Evakuierungskanäle 21, 22 sind kontinuierlich mit den Ringkanälen 41 bzw. 42 verbunden, da letztere vollständig umlaufend ausgebildet sind. Folglich stellt die Drehzuführung eine kontinuierliche Verbindung über den gesamten Drehwinkel von 360° her.

Zwei weitere Evakuierungskanäle zur Verbindung mit den Ringkanälen 43 bzw. 44 sind ebenfalls in dem Zapfen 2 vorhanden, aber in der Schnittdarstellung in Fig. 2 nicht zu sehen, da diese in der gezeigten Position der Drehdurchführung 82 senkrecht zur Schnittebene liegen.

Die Evakuierungskanäle 21, 22 weisen jeweils einen axialen Kanalabschnitt 23 bzw. 24 und einen damit verbunden radialen Kanalabschnitt 25 bzw. 26 auf, welche in der Mantelfläche 28 des Zapfens 2 und in dem zugeordneten Ringkanal 41 bzw. 42 münden.

Beidseits der Ringkanäle befindet sich jeweils eine Ringdichtung 30.

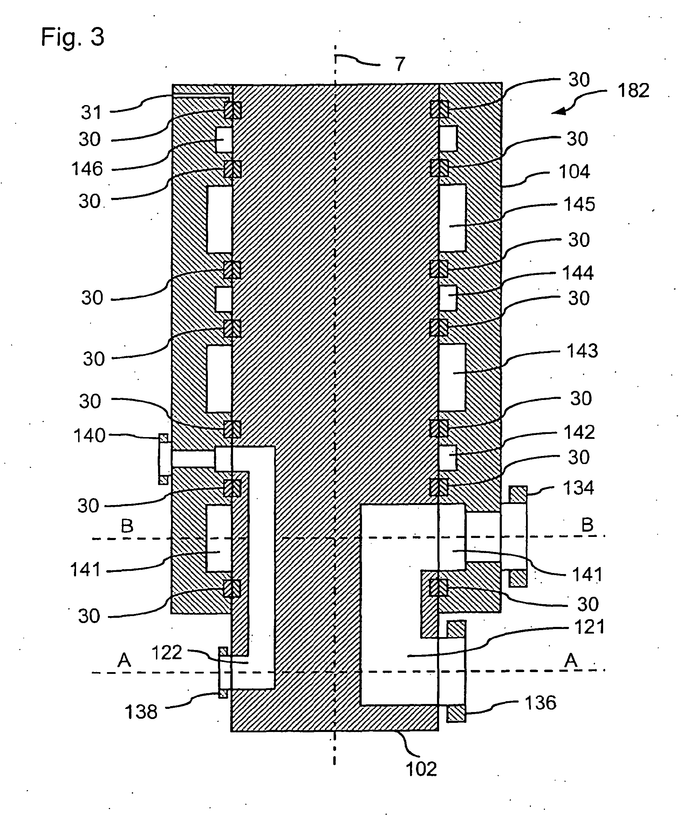

Bezug nehmend auf Fig. 3 ist eine weitere Ausführungsform der Drehdurchführung 182 dargestellt. Der Zapfen 102 weist sechs Fluidkanäle auf, von denen zwei unterschiedlich dimensionierte Fluidkanäle 121, 122 dargestellt sind. Jedem Fluidkanal ist einer von sechs Ringkanälen 141 bis 146 zugeordnet.

Über den Fluidkanal 121 werden die Behandlungseinrichtungen evakuiert und über den Fluidkanal 122 wird den Behandlungseinrichtungen Prozessgas zugeführt. Die Fluidkanäle sind im Wesentlichen U-förmig ausgestaltet und umfassen je einen axialen Abschnitt, welcher sich entlang der Rotationsachse 7 erstreckt.

Die Behandlungseinrichtungen sind über Rohre gegebenenfalls unter Zwischenschaltung einer Vakuumpumpe an einem Anschlussflansch 134 angeschlossen. Auf der anderen Seite des Kanals 121 werden ortsfeste Pumpen an einen unteren Anschlussflansch 136 angeschlossen. Entsprechend ist gaszuführungsseitig eine Gasversorgungseinrichtung über einen Anschlussflansch 138, den Gasversorgungskanal 122 und einen Anschlussflansch 140 mit den Behandlungseinrichtungen verbunden.

Alle Dichtungen 30 werden über Dichtmittelleitungen kontinuierlich mit Vakuumöl geschmiert. Der Übersichtlichkeit halber ist lediglich eine Dichtmittelleitung 31 an der obersten Dichtung dargestellt.

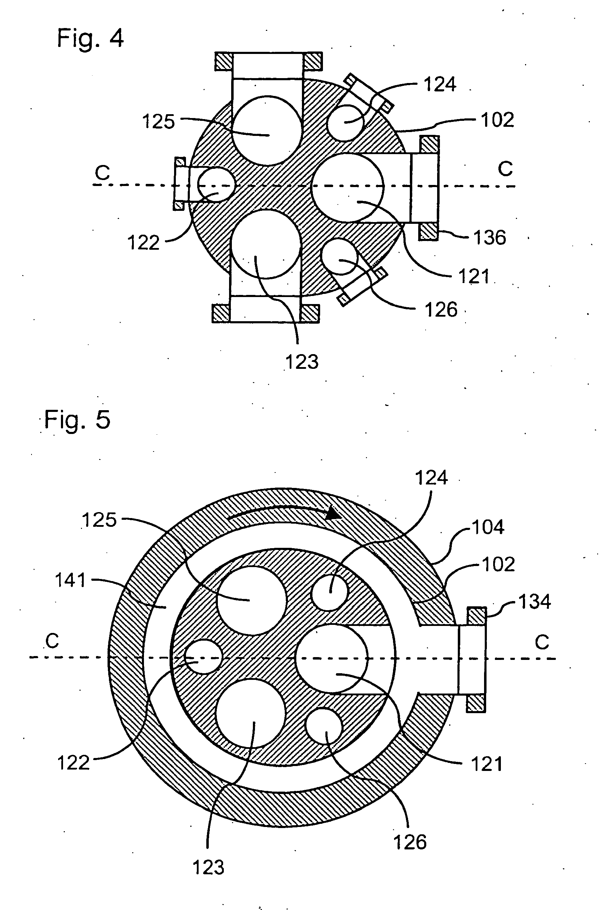

Bezug nehmend auf Fig. 4 weist die Drehdurchführung 182 drei Evakuierungskanäle 121, 123 und 125 auf. Die Evakuierungskanäle sind mit einem Winkelabstand von etwa 120° um die Achse verteilt. Zwischen den Evakuierungskanälen befinden sich drei Gaszuführungskanäle 122, 124 und 126.

Bezug nehmend auf Fig. 5 ist der umlaufende Ringkanal 141 dargestellt. Rotiert die Hülse 104 um den Zapfen 102, besteht über den Ringkanal 141 eine dauerhafte Fluidverbindung zwischen dem Evakuierungskanal 121 und dem Anschlussflansch 134.

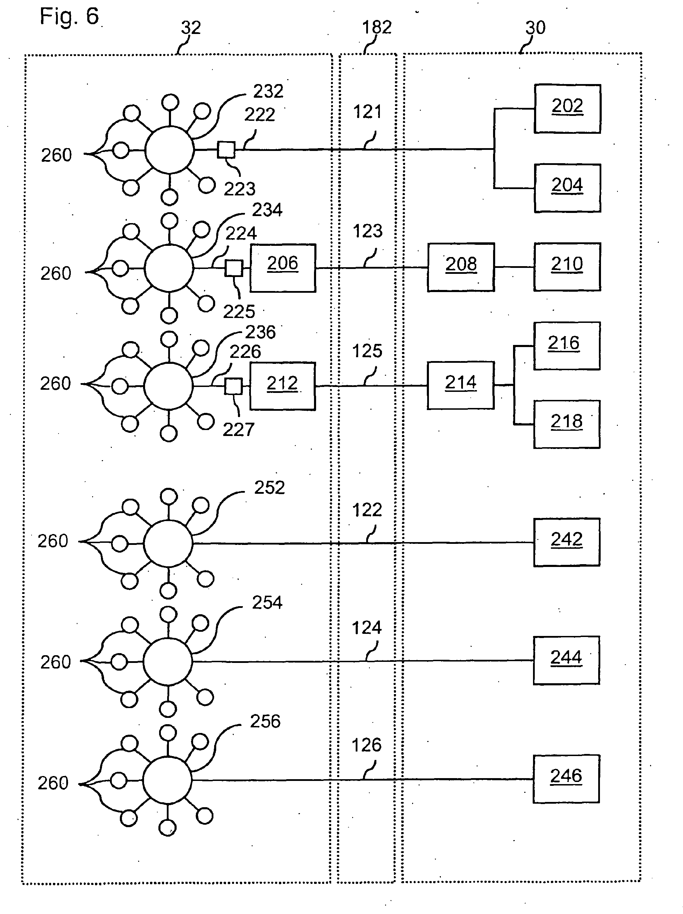

Ein Beschichtungszyklus wird Bezug nehmend auf Fig. 6 wie folgt durchgeführt. In einer ersten Pumpphase wird die Behandlungseinrichtung mittels einer ersten Pumpenanordnung umfassend zwei parallel geschaltete Drehschieber-Vorvakuumpumpen 202, 204, auf ein Vorvakuum zwischen etwa 100 mbar und 1 mbar evakuiert. Die Zuleitungen werden über den Evakuierungskanal 121 in der Drehdurchführung 182 auf den Rotor 32 geführt. Die Drehschieberpumpen 202 und 204 haben eine Pumpleistung von jeweils 1200 Norm-m³/h.

Bei der geforderten Maschinenleistung ist die Zeit, bis der nächste Behälter eingefördert wird, sehr kurz. Daher ist eine zweite Evakuierungsphase vorgesehen, um stufenweise abzupumpen. In der zweiten Evakuierungsphase werden die Behandlungseinrichtungen über eine serielle zweite Pumpenanordnung, umfassend eine erste Wälzkolbenpumpe 206, eine zweite Wälzkolbenpumpe 208 und eine Drehschieberpumpe 210 evakuiert.

Die Wälzkolbenpumpe 206 weist eine Pumpleistung von 4000 Norm-m³/h, die zweite Wälzkolbenpumpe 208 von 1000 Norm-m³/h und die Drehschieberpumpe von 100 Norm-m³/h auf. Die Behandlungseinrichtungen werden in der zweiten Evakuierungsphase von dem Vorvakuum auf einen Basisdruck von etwa 0,05 bis 0,8 mbar evakuiert, welches den Druck vor dem Beschichtungsbeginn darstellt.

Nachfolgend werden die Werkstücke in einer ersten Beschichtungsphase unter Durchfluss eines ersten Prozessgases, welches über den Kanal 124 zugeleitet wird, mit einer ersten Beschichtung versehen.

Nach der ersten Beschichtungsphase folgt eine zweite Beschichtungsphase, in welcher die Werkstücke unter Durchfluss eines zweiten Prozessgases über den Kanal 126 mit einer Barriereschicht beschichtet werden.

Während der ersten und zweiten Beschichtungsphase sind die Behandlungseinrichtungen mit einer seriellen dritten Pumpenanordnung, umfassend eine erste Wälzkolbenpumpe 212, eine zweite Wälzkolbenpumpe 214 und zwei parallel geschaltete Drehschiebervorpumpen 216 und 218 verbunden.

Die Wälzkolbenpumpe 212 weist eine Pumpleistung von 5550 Norm-m³/h, die Wälzkolbenpumpe 214 eine Pumpleistung von 2000 Norm-m³/h und die Drehschiebervorpumpen 216 und 218 von jeweils 100 Norm-m³/h auf.

Vorteilhafterweise werden für die Evakuierungs- und Beschichtungsphasen getrennte Pumpenanordnungen verwendet. Dies ist vorteilhaft, da während dem Beschichtungsprozess Stäube Ablagerungen in den Leitungen und Pumpen erzeugen. Bei dem Ausführungsbeispiel ist dies auf die Pumpen 212, 214, 216 und 218 begrenzt, und eine Verunreinigung in den Pumpenanordnungen für die Evakuierungsphasen wird vermieden. Somit wird auch das Eindringen von Stäuben aus den Beschichtungsphasen auf die Dichtungen 30 der Evakuierungskanäle 121 und 123 verhindert. Entsprechend verringert sich dort der Verschleiß an den Dichtungen, wodurch Leckagen vermieden werden.

Die Pumpen 202, 204, 208, 210, 214, 216 und 218 sind ortsfest außerhalb des Rotors angeordnet, wohingegen die Pumpen 206 und 212 an dem Rotor angeordnet sind und mitrotieren. Somit ist also für zumindest eine Prozessphase (Evakuierungsphase oder Beschichtungsphase) die Fluiddrehdurchführung zwischen zumindest zwei in Serie geschalteten Vakuumpumpen angeordnet.

Daraus resultiert der Vorteil, dass die Drehdurchführung 182 lediglich in einem Druckbereich von > 1 mbar arbeitet, da die beiden Wälzkolbenpumpen 206 und 212 auf dem Rotor bereits eine Vorkomprimierung vornehmen. Aufgrund dessen ist die Abdichtung der Drehdurchführung erheblich vereinfacht. Für einen einwandfreien Betrieb genügt eine Leckrate von etwa < 10⁻² mbar *l/sec. Ferner genügen Leitungsquerschnitte von etwa 100 mm.

Nach dem Erreichen des vorgesehenen Basisdrucks wird der Beschichtungsprozess durchgeführt. Zumindest während der zweiten Beschichtungsphase sind mehrere Behandlungseinrichtungen gleichzeitig mit der Pumpenanordnung 212, 214, 216, 218 verbunden.

Nach dem Beschichten werden die Behandlungseinrichtungen auf Umgebungsdruck belüftet, geöffnet und das Werkstück aus der Vorrichtung hinaus befördert.

Bezüglich der Steuerung der Prozessphasen wird auf die Anmeldung "Vorrichtung und Verfahren zur Behandlung von Werkstücken" derselben Anmelderin, angemeldet am selben Tag, verwiesen.

Der Druck oder genauer der Unterdruck in den Vakuumleitungen 222, 224 und 226 wird über jeweils einen separaten Druckregler 223, 225, 227 eingestellt und über je einen Ringverteiler 232, 234 bzw. 236 auf die Behandlungseinrichtungen verteilt. Die zeitliche Steuerung wird über zwei Ventilanordnungen oder Ventilblöcke umfassend Ventile 240 bewerkstelligt, wobei jeder Behandlungseinrichtung für jede Pumpenanordnung jeweils ein Ventil zugeordnet ist. Hierdurch kann die Prozesssteuerung, angepasst an die Beschichtungsanforderungen, variabel programmiert werden.

Die Gaszuführung zu den Behandlungseinrichtungen ist analog aufgebaut. Das Prozessgas für die erste und zweite Beschichtungsphase wird von einer ersten bzw. zweiten Fluid-Quelle 242 bzw. 244 bereitgestellt. Das Prozessgas wird über die Kanäle 122 bzw. 124 in der Drehdurchführung 182 auf den Rotor gefördert, wo es kontinuierlich zur weiteren Verteilung und Steuerung bereitsteht. Über den verbleibenden Kanal 126 wird ein Spülgas aus einer Quelle 246 zum Spülen der Behandlungseinrichtungen auf den Rotor befördert.

Stromabwärts der Drehdurchführung 182 werden die Prozessgase und das Spülgas mittels Verteilern 252, 254 und 256 auf die
Behandlungseinrichtungen verteilt. Die zeitliche Steuerung wird mittels Ventilen 260, welche zwischen den Behandlungseinrichtungen und den Verteilern 252, 254 und 56 angeordnet sind, bewerkstelligt.

## Patentansprüche

1. Vorrichtung (1) zur Behandlung von Werkstücken, insbesondere zur Plasmabeschichtung von Hohlkörpern unter Fluidbeaufschlagung, umfassend
zumindest eine Behandlungseinrichtung (101) zur Aufnahme zumindest eines Werkstücks,
einen Rotor (32), an welchem die Behandlungseinrichtung (101) angeordnet ist,
eine Fluiddrehdurchführung (82, 182) zum Zuführen zumindest eines Fluids auf den Rotor (32) und/oder zum Abführen zumindest eines Fluids von dem Rotor (32),
wobei die Fluiddrehdurchführung (82, 182) einen Zapfen (2, 102) und eine Hülse (4, 104) aufweist, welche zumindest abschnittsweise gegeneinander gedichtet sind und der Zapfen (2, 102) rotierbar in der Hülse (4, 104) angeordnet ist **dadurch gekennzeichnet,**
**dass** zumindest eine Vakuumpumpe (206, 212) auf dem Rotor (32) angeordnet ist.

2. Vorrichtung (1) nach Anspruch 1,
**dadurch gekennzeichnet, dass**
der Zapfen (2, 102) einen Fluidkanal (121 - 126) aufweist, durch welchen Fluid der Behandlungseinrichtung (101) auf dem Rotor (32) zugeführt, bzw. Fluid aus der Behandlungseinrichtung (101) auf dem Rotor (32) abgeführt wird.

3. Vorrichtung (1) nach einem der vorstehenden Ansprüche,
**dadurch gekennzeichnet, dass**
der Zapfen (2, 102) und die Hülse (4, 104) jeweils einen Leitungsanschluss (134, 136) aufweisen, welche über den Fluidkanal (121 - 136) miteinander verbunden sind, so dass ein Fluidfluss ermöglicht ist.

4. Vorrichtung (1) nach einem der vorstehenden Ansprüche,
**dadurch gekennzeichnet, dass**
das der Zapfen (2, 102) im wesentlichen zylinderförmig und die Hülse (4, 104) im wesentlichen hohlzylinderförmig ausgebildet sind und der Zapfen konzentrisch in der Hülse angeordnet ist und sich die Fluiddrehdurchführung (82, 182) entlang der Rotorachse (7) erstreckt.

5. Vorrichtung (1) nach einem der vorstehenden Ansprüche,
**dadurch gekennzeichnet, dass**
die Hülse (4, 104) drehfest an dem Rotor (32) befestigt ist und mit diesem mitrotiert.

6. Vorrichtung nach einem der Ansprüche 1 bis 4,
**dadurch gekennzeichnet, dass**
der Zapfen (2, 102) drehfest an dem Rotor (32) befestigt ist und mit diesem mitrotiert.

7. Vorrichtung nach einem der vorstehenden Ansprüche,
**dadurch gekennzeichnet, dass**
der Zapfen (2, 102) zumindest einen Kanal (21) mit einem axialen und einem radialen Kanalabschnitt (23, 25) aufweist, wobei der radiale Kanalabschnitt (25) in der Mantelfläche (28) des Zapfens (2, 102) mündet.

8. Vorrichtung (1) nach einem der vorstehenden Ansprüche,
**dadurch gekennzeichnet, dass**
die Hülse (4, 104) oder der Zapfen (2, 102) zumindest einen Ringkanal (41 - 44) um den Zapfen aufweist,
wobei der axiale Kanalabschnitt (23), der radiale Kanalabschnitt (25) und der Ringkanal (21) einen Fluidkanal bilden.

9. Vorrichtung (1) nach einem der vorstehenden Ansprüche,
**gekennzeichnet durch**
Dichtmittelleitungen in der Fluiddrehdurchführung (82, 182).

10. Vorrichtung (1) nach Anspruch 8 oder 9,
**gekennzeichnet durch**
zumindest eine erste und zweite Dichtung (30), welche axial versetzt an einer ersten bzw. zweiten Seite des Ringkanals (41 - 44) angeordnet sind, wobei die erste und zweite Dichtung (30) als Ringdichtung ausgebildet sind.

11. Vorrichtung (1) nach Anspruch 9 oder 10,
**dadurch gekennzeichnet, dass**
die Dichtungen (30) mit Öl geschmiert sind.

12. Vorrichtung (1) nach einem der vorstehenden Ansprüche,
**dadurch gekennzeichnet, dass**
der Ringkanal (141 - 146) umlaufend ausgebildet ist und Leitungsanschlüsse (124, 126, 128, 130) des Zapfens und der Hülse während der Drehung des Rotors (32) kontinuierlich miteinander verbunden sind.

13. Vorrichtung (1) nach einem der vorstehenden Ansprüche,
**dadurch gekennzeichnet, dass**
die Hülse (4, 104) eine Mehrzahl von radial angeordneten und sternartig verteilten Leitungsanschlüssen (511, 512) aufweist, wobei jeder Behandlungseinrichtung (101) ein Leitungsanschluss zugeordnet ist.

14. Vorrichtung (1) nach einem der vorstehenden Ansprüche,
**gekennzeichnet durch**
eine Mehrzahl von Fluidkanälen (21 - 24), wobei der Zapfen (2, 102) eine Mehrzahl von Känalen mit jeweils einem axialen und einem radialen Kanalabschnitt (23, 24; 25, 26) aufweist, wobei die radialen Kanalabschnitte (25, 26) in der Mantelfläche (28) des Zapfens (2, 102) münden und die axialen Kanalabschnitte (23, 24) ringartig versetzt sind.

15. Vorrichtung (1) nach einem der vorstehenden Ansprüche,
**dadurch gekennzeichnet, dass**
die Behandlungseinrichtung (101) im Betrieb während der Evakuierungsphase zumindest eine Vakuumpumpe (202, 204), welche mit einem ersten Fluidkanal (121) verbunden ist und während der Beschichtungsphase zumindest eine zweite Vakuumpumpe (212, 214), welche mit einem zweiten Evakuierungskanal (125) verbunden ist, aufweist.

16. Vorrichtung (1) nach einem der vorstehenden Ansprüche,
**dadurch gekennzeichnet, dass**
die Hülse (4, 104) oder der Zapfen (2, 102) eine Mehrzahl von Ringkanälen (41 - 44) aufweisen, welche mit jeweils einem der radialen Kanalabschnitte (25, 26) verbunden sind, wobei jeweils ein radialer Kanalabschnitt (25, 26) und ein zugeordneter Ringkanal auf einer Ebene liegen und die verschiedenen Ringkanäle (41 - 44) axial zueinander versetzt sind.

17. Vorrichtung (1) nach einem der vorstehenden Ansprüche,
**dadurch gekennzeichnet, dass**
zwischen den Ringkanälen (41 - 44) jeweils zumindest eine Ringdichtung (30) vorgesehen ist.

18. Vorrichtung (1) nach einem der vorstehenden Ansprüche,
**dadurch gekennzeichnet, dass**
die Vorrichtung eine ventilanordnung (260) zum zeitlich steuerbaren Zu- bzw. Abführen des Fluids umfasst.

19. Vorrichtung (1) nach einem der vorstehenden Ansprüche,
**dadurch gekennzeichnet, dass**
die Fluiddrehdurchführung (82, 182) zumindest einen Gaszuführungskanal (122) zur Zuführung beziehungsweise Abführung eines Fluids und einen Evakuierungskanal (121) zum Abführen eines Fluids beziehungsweise zum Evakuieren der Behandlungseinrichtung (101) auf dem Rotor mittels einer Vakuumpumpe (206 - 218), umfasst.

20. Vorrichtung (1) nach Anspruch 19,
**dadurch gekennzeichnet, dass**
der Evakuierungskanal (121) einen Innendurchmesser von 25 mm bis 250 mm und der Gaszuführungskanal (122) einen Innendurchmesser von 5 mm bis 50 mm aufweisen.

21. Vorrichtung (1) nach einem der vorstehenden Ansprüche,
**dadurch gekennzeichnet, dass**
die Fluiddrehdurchführung (82, 182) eine Mehrzahl von Gaszuführungskanälen (122, 124, 126) und eine Mehrzahl von Evakuierungskanälen (121, 123, 125) aufweist.

22. Vorrichtung (1) nach einem der vorstehenden Ansprüche,
**dadurch gekennzeichnet, dass**
die Behandlungseinrichtung (101) Vakuumpumpen (206 218) zur mehrstufigen Evakuierung des Werkstücks während der Behandlung umfasst, wobei zumindest eine der Vakuumpumpen auf dem Rotor angeordnet ist.

23. Fluiddrehdurchführung (82, 182), hergerichtet für eine Vorrichtung zur Behandlung von Werkstücken mit zumindest einer Behandlungseinrichtung (101) zur Aufnahme zumindest eines Werkstücks und einem Rotor (32), an welchem die Behandlungseinrichtung (101) angeordnet ist, insbesondere hergerichtet für eine Vorrichtung (1) zur Plasmabeschichtung von Hohlkörpern unter Fluidbeaufschlagung gemäß einem der vorstehenden Ansprüche,
wobei die Fluiddrehdurchführung (82, 182) einen Zapfen (2, 102) und eine Hülse (4, 104) umfasst, welche zumindest abschnittsweise gegeneinander gedichtet sind,
wobei der Zapfen und die Hülse jeweils einen Leitungsanschluss (134, 136) aufweisen, welche über einen Fluidkanal (121) in der Fluiddrehdurchführung (82, 182) zumindest zeitweise miteinander verbunden sind, so dass ein Fluidfluss durch die Fluiddrehdurchführung (82, 182) ermöglicht ist und
wobei der Zapfen (2, 102) rotierbar in der Hülse (4, 104) angeordnet ist **dadurch gekennzeichnet,**
**dass** zumindest eine Vakuumpumpe (206, 212) auf dem Rotor (32) angeordnet ist.

## Claims

1. Device (1) for the treatment of workpieces, in particular for plasma coating hollow bodies by the action of a fluid, comprising
at least one treatment device (101) for receiving at least one workpiece,
a rotor (32) on which the treatment device (101) is disposed,
a rotational fluid passage (82, 182) for supplying at least one fluid onto the rotor (32) and/or for carrying away at least one fluid from the rotor (32), wherein the rotational fluid passage (82, 182) has a spigot (2, 102) and a sleeve (4, 104), which are sealed with respect to each other at least in portions, and the spigot (2, 102) is disposed so as to be able to rotate within the sleeve (4, 104), **characterised in that**
at least one vacuum pump (206, 212) is disposed on the rotor (32).

2. Device (1) as claimed in claim 1, **characterised in that** the spigot (2, 102) has a fluid duct (121 - 126) through which fluid is supplied to the treatment device (101) on the rotor (32) or fluid is carried away from the treatment device (101) on the rotor (32).

3. Device (1) as claimed in any one of the preceding claims, **characterised in that** the spigot (2, 102) and the sleeve (4, 104) each have a line connection (134, 136), which are connected to each other by the fluid duct (121 - 136) so that a flow of fluid is made possible.

4. Device (1) as claimed in any one of the preceding claims, **characterised in that** the spigot (2, 102) is formed substantially as a cylinder and the sleeve (4, 104) is formed substantially as a hollow cylinder and the spigot is disposed concentrically within the sleeve and the rotational fluid passage (82, 182) extends along the rotor axis (7).

5. Device (1) as claimed in any one of the preceding claims, **characterised in that** the sleeve (4, 104) is attached in a rotationally fixed manner on the rotor (32) and rotates therewith.

6. Device as claimed in any one of the claims 1 to 4, **characterised in that** the spigot (2, 102) is attached in a rotationally fixed manner on the rotor (32) and rotates therewith.

7. Device as claimed in any one of the preceding claims, **characterised in that** the spigot (2, 102) has at least one duct (21) with an axial and a radial duct portion (23, 25), wherein the radial duct portion (25) issues in the outer surface (28) of the spigot (2, 102).

8. Device (1) as claimed in any one of the preceding claims, **characterised in that** the sleeve (4, 104) or the spigot (2, 102) has at least one annular duct (41 - 44) around the spigot, wherein the axial duct portion (23), the radial duct portion (25) and the annular duct (21) form a fluid duct.

9. Device (1) as claimed in any one of the preceding claims, **characterised by** sealing agent lines in the rotational fluid passage (82, 182).

10. Device (1) as claimed in claim 8 or 9, **characterised by** at least a first and a second seal (30), which are disposed in an axially offset manner on a first and a second side of the annular duct (41 - 44), wherein the first and second seal (30) are formed as an annular seal.

11. Device (1) as claimed in claim 9 or 10, **characterised in that** the seals (30) are lubricated with oil.

12. Device (1) as claimed in any one of the preceding claims, **characterised in that** the annular duct (141 - 146) is formed in a peripheral manner and line connections (124, 126, 128, 130) of the spigot and of the sleeve are continually connected to each other during rotation of the rotor (32).

13. Device (1) as claimed in any one of the preceding claims, **characterised in that** the sleeve (4, 104) has a plurality of radially disposed line connections (511, 512) distributed in a star-like manner, wherein each treatment device (101) is allocated a line connection.

14. Device (1) as claimed in any one of the preceding claims, **characterised by** a plurality of fluid ducts (21 - 24), wherein the spigot (2, 102) has a plurality of ducts, each with an axial and a radial duct portion (23, 24; 25, 26), wherein the radial duct portions (25, 26) issue in the outer surface (28) of the spigot (2, 102) and the axial duct portions (23, 24) are offset in an annular manner.

15. Device (1) as claimed in any one of the preceding claims, **characterised in that** in operation during the evacuation phase the treatment device (101) has at least one vacuum pump (202, 204), which is connected to a first fluid duct (121), and during the coating phase the treatment device (101) has at least one second vacuum pump (212, 214) which is connected to a second evacuation duct (125).

16. Device (1) as claimed in any one of the preceding claims, **characterised in that** the sleeve (4, 104) or the spigot (2, 102) have a plurality of annular ducts (41 - 44) which are connected to a respective one of the radial duct portions (25, 26), wherein in each case a radial duct portion (25, 26) and an associated annular duct lie on a plane and the different annular ducts (41 - 44) are axially offset with respect to each other.

17. Device (1) as claimed in any one of the preceding claims, **characterised in that** between the annular ducts (41 - 44) in each case at least one annular seal (30) is provided.

18. Device (1) as claimed in any one of the preceding claims, **characterised in that** the device has a valve arrangement (260) in order to supply and discharge the fluid in a controllable manner in relation to time.

19. Device (1) as claimed in any one of the preceding claims, **characterised in that** the rotational fluid passage (82, 182) has at least one gas supply duct (122) for supplying or discharging a fluid, and an evacuation duct (121) for discharging a fluid or evacuating the treatment device (101) on the rotor by means of a vacuum pump (206 - 218).

20. Device (1) as claimed in claim 19, **characterised in that** the evacuation duct (121) has an internal diameter of 25 mm to 250 mm and the gas supply duct (122) has an internal diameter of 5 mm to 50 mm.

21. Device (1) as claimed in any one of the preceding claims, **characterised in that** the rotational fluid passage (82, 182) has a plurality of gas supply ducts (122, 124, 126) and a plurality of evacuation ducts (121, 123, 125).

22. Device (1) as claimed in any one of the preceding claims, **characterised in that** the treatment device (101) comprises vacuum pumps (206 - 218) for multi-stage evacuation of the workpiece during the treatment, wherein at least one of the vacuum pumps is disposed on the rotor.

23. Rotational fluid passage (82, 182), arranged for a device for treating workpieces with at least one treatment device (101) for receiving at least one workpiece and a rotor (32), on which the treatment device (101) is disposed, in particular arranged for a device (1) for plasma coating hollow bodies by the action of a fluid in accordance with any one of the preceding claims,
wherein the rotational fluid passage (82, 182) has a spigot (2, 102) and a sleeve (4, 104) which are sealed with respect to each other at least in portions,
wherein the spigot and the sleeve each have a line connection (134, 136), which are connected to each other at least part of the time via a fluid duct (121) in the rotational fluid passage (82, 182) so that a fluid flow through the rotational fluid passage (82, 182) is made possible, and
wherein the spigot (2, 102) is disposed so as to be able to rotate within the sleeve (4, 104), **characterised in that** at least one vacuum pump (206, 212) is disposed on the rotor (32).

## Revendications

1. Dispositif (1) pour le traitement de pièces, en particulier pour le revêtement par plasma de corps creux avec alimentation en fluide, comprenant
au moins un dispositif de traitement (101) pour le logement d'au moins une pièce,
un rotor (32), sur lequel le dispositif de traitement (101) est disposé,
un passage rotatif de fluide (82, 182) pour l'arrivée d'au moins un fluide au rotor (32) et/ou pour l'évacuation d'au moins un fluide du rotor (32), le passage rotatif de fluide (82, 182) présentant un pivot (2, 102) et une douille (4, 104) lesquels sont étanchés au moins en partie l'un par rapport à l'autre, et le pivot (2, 102) étant disposé de façon rotative dans la douille (4, 104), **caractérisé**
**en ce qu'**au moins une pompe à vide (206, 212) est disposée sur le rotor (32).

2. Dispositif (1) selon la revendication 1
**caractérisé en ce que**
le pivot (2, 102) présente un canal à fluide (121 - 126), par lequel du fluide est amené au dispositif de traitement (101) sur le rotor (32), et du fluide provenant du dispositif de traitement (101) est évacué sur le rotor (32).

3. Dispositif (1) selon l'une des revendications précédentes,
**caractérisé en ce que**
le pivot (2, 102) et la douille (4, 104) présentent respectivement un branchement de conduite (134, 136), lesquels sont reliés entre eux par le canal à fluide (121 - 136), ce qui permet un écoulement de fluide.

4. Dispositif (1) selon l'une des revendications précédentes,
**caractérisé en ce que**
le pivot (2, 102) est réalisé sensiblement en forme de cylindre et la douille (4, 104) sensiblement en forme de cylindre creux, et le pivot est disposé de façon concentrique dans la douille et le passage rotatif de fluide (82, 182) s'étend le long de l'axe du rotor (7).

5. Dispositif (1) selon l'une des revendications précédentes,
**caractérisé en ce que**
la douille (4, 104) est fixée de façon solidaire en rotation sur le rotor (32) et tourne avec celui-ci.

6. Dispositif selon l'une des revendications 1 à 4,
**caractérisé en ce que**
le pivot (2, 102) est fixé de façon solidaire en rotation sur le rotor (32) et tourne avec celui-ci.

7. Dispositif selon l'une des revendications précédentes,
**caractérisé en ce que**
le pivot (2, 102) présente au moins un canal (21) avec une partie de canal axiale et une partie de canal radiale (23, 25), la partie de canal (25) radiale débouchant dans la surface d'enveloppe (28) du pivot (2, 102).

8. Dispositif (1) selon l'une des revendications précédentes,
**caractérisé en ce que**
la douille (4, 104) ou le pivot (2, 102) présente au moins un canal annulaire (41 - 44) autour du pivot,
la partie de canal (23) axiale, la partie de canal (25) radiale et le canal annulaire (21) formant un canal à fluide.

9. Dispositif (1) selon l'une des revendications précédentes,
**caractérisé par**
des conduites de produit d'étanchéité dans le passage rotatif de fluide (82, 182).

10. Dispositif (1) selon la revendication 8 ou 9,
**caractérisé par**
au moins un premier et un second joint (30), lesquels sont disposés avec un décalage axial sur un premier ou un second côté du canal annulaire (41 - 44), le premier et le second joint (30) étant conçus comme des joints annulaires.

11. Dispositif (1) selon la revendication 9 ou 10,
**caractérisé en ce que**
les joints (30) sont lubrifiés avec de l'huile.

12. Dispositif (1) selon l'une des revendications précédentes,
**caractérisé en ce que**
le canal annulaire (141 - 146) est conçu périphérique et des branchements de conduite (124, 126, 128, 130) du pivot et de la douille sont reliés de façon continue l'un à l'autre pendant la rotation du rotor (32).

13. Dispositif (1) selon l'une des revendications précédentes,
**caractérisé en ce que**
la douille (4, 104) présente une pluralité de branchements de conduite (511, 512) disposés radialement et répartis en forme d'étoile, un branchement de conduite étant attribué à chaque dispositif de traitement (101).

14. Dispositif (1) selon l'une quelconque des revendications précédentes,
**caractérisé par**
une pluralité de canaux à fluide (21 - 24), le pivot (2, 102) présentant une pluralité de canaux comprenant une partie de canal axiale et une partie de canal radiale (23, 24 ; 25, 26), les parties de canal (25, 26) radiales débouchant dans la surface d'enveloppe (28) du pivot (2, 102) et les parties de canal (23, 24) axiales étant décalées à la façon d'un anneau.

15. Dispositif (1) selon l'une des revendications précédentes,
**caractérisé en ce que**
le dispositif de traitement (101) présente en fonctionnement pendant la phase d'obtention du vide au moins une pompe à vide (202, 204), qui est reliée à un premier canal à fluide (121) et pendant la phase de revêtement au moins une seconde pompe à vide (212, 214), qui est reliée à un second canal d'obtention de vide (125).

16. Dispositif (1) selon l'une quelconque des revendications précédentes,
**caractérisé en ce que**
la douille (4, 104) ou le pivot (2, 102) présente une pluralité de canaux annulaires (41 - 44), qui sont reliés chacun à l'une des parties de canal (25, 26) radiales, à chaque fois une partie de canal (25, 26) radiale et un canal annulaire attribué étant situés sur un plan et les différents canaux annulaires (41 - 44) étant décalés axialement les uns par rapport aux autres.

17. Dispositif (1) selon l'une des revendications précédentes,
**caractérisé en ce que**
à chaque fois au moins un joint annulaire (30) est prévu entre les canaux annulaires (41 - 44).

18. Dispositif (1) selon l'une des revendications précédentes,
**caractérisé en ce que**
le dispositif comprend un agencement de soupape (260) pour l'arrivée ou l'évacuation contrôlable dans le temps du fluide.

19. Dispositif (1) selon l'une des revendications précédentes,
**caractérisé en ce que**
le passage rotatif de fluide (82, 182) présente au moins un canal de guidage de gaz (122) pour l'arrivée ou l'évacuation d'un fluide et un canal d'obtention de vide (121) pour l'évacuation d'un fluide respectivement pour la mise sous vide du dispositif de traitement (101) sur le rotor au moyen d'une pompe à vide (206 - 218).

20. Dispositif (1) selon la revendication 19,
**caractérisé en ce que**
le canal d'obtention de vide (121) présente un diamètre intérieur de 25 mm à 250 mm et le canal d'arrivée de gaz (122) un diamètre intérieur de 5 mm à 50 mm.

21. Dispositif (1) selon l'une des revendications précédentes,
**caractérisé en ce que**
le passage rotatif de fluide (82, 182) présente une pluralité de canaux d'arrivée de gaz (122, 124, 126) et une pluralité de canaux d'obtention de vide (121, 123, 125).

22. Dispositif (1) selon l'une quelconque des revendications précédentes,
**caractérisé en ce que**
le dispositif de traitement (101) comprend des pompes à vide (206 - 218) pour la mise sous vide en plusieurs étapes de la pièce pendant le traitement, au moins l'une des pompes à vide étant disposée sur le rotor.

23. Passage rotatif de fluide (82, 182), préparé pour un dispositif pour le traitement de pièces avec au moins un dispositif de traitement (101) pour le logement d'au moins une pièce et un rotor (32), sur lequel le dispositif de traitement (101) est disposé, en particulier préparé pour un dispositif (1) pour le revêtement par plasma de corps creux avec alimentation en fluide selon l'une des revendications précédentes,
le passage rotatif de fluide (82, 182) comportant un pivot (2, 102) et une douille (4, 104), lesquels sont étanchés au moins en partie l'un par rapport à l'autre,
le pivot et la douille présentant chacun un branchement de conduite (134, 136), lesquels sont reliés au moins temporairement l'un à l'autre par un canal à fluide (121) dans le passage rotatif de fluide (82, 182), de sorte qu'un écoulement de fluide est rendu possible par le passage rotatif de fluide (82, 182), et
le pivot (2, 102) étant disposé de façon rotative dans la douille (4, 104), **caractérisé en ce que**
au moins une pompe à vide (206, 212) est disposée sur le rotor (32).
